(19) Europäisches Patentamt

European Patent Office

Office européen des brevets

(11) **EP 0 991 187 A2**

(12) **EUROPEAN PATENT APPLICATION**

(43) Date of publication:
05.04.2000 Bulletin 2000/14

(51) Int. Cl.[7]: **H03H 17/06**

(21) Application number: **99119295.6**

(22) Date of filing: **28.09.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **29.09.1998 JP 27565598**

(71) Applicant: **NEC CORPORATION
Tokyo (JP)**

(72) Inventor:
**Misu, Katsuya,
c/oNEC IC Microcomputer Sys., Ltd.
Kawasaki-shi, Kanagawa (JP)**

(74) Representative:
**Glawe, Delfs, Moll & Partner
Patentanwälte
Postfach 26 01 62
80058 München (DE)**

(54) **Digital filter for filtering finite input data**

(57)    Delay device 1 has an array of delay elements equal in number to the sum of the number N of sequential input data and the delay number p. At the initial setting of the filter process, 0 is stored in the p delay elements from the first end of the array Y1, and the N input data are sequentially stored in the order of the sequence of the input data in the N delay elements from the [p+1]th delay element counting from the first end toward the second end Y2. First pointing device PM1 designates the delay element that stores data of the first term of a sum-of-products calculation, and shifts the designated location each time interval corresponding to the delay time of delay device 1. Second pointing device PM2 designates delay elements that store data to be multiplied by tap coefficients.

Fig. 2

EP 0 991 187 A2

**Description**

BACKGROUND OF THE INVENTION

1. Field of the Invention:

The present invention relates to a digital filter having a finite number of input data samples in a general-purpose microcomputer.

2. Description of related art

The operating frequency of general-purpose microcomputers has increased in recent years, and general-purpose microcomputers are now being introduced that incorporate multimedia instructions such as sum-of-products instructions. With this development, general-purpose microcomputers and software are now realizing filter processing that was previously carried out by a DSP (Digital Signal Processor). Digital filter processing in general-purpose microcomputers was formerly realized by a ring buffer FIR (Finite Impulse Response) digital filter.

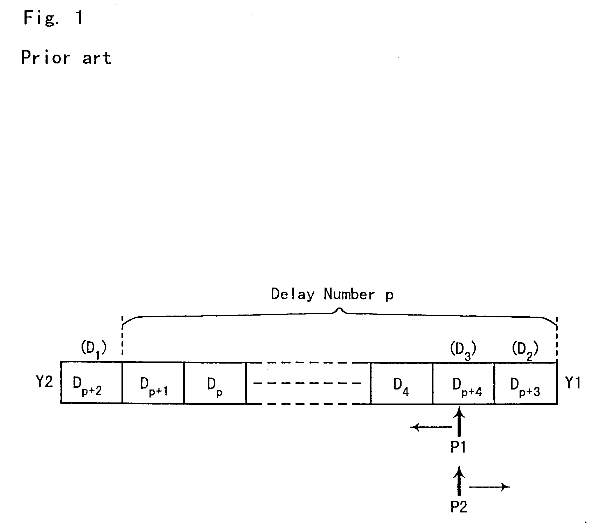

Fig. 1 shows the configuration of the principal parts of a ring-buffer-type digital filter having a delay number p. This filter is provided with p+1 buffers, input data pointer P1, and delay data pointer P2. Input data pointer P1 designates the location of storage of input data.

Delay data pointer P2 designates the location of the buffer that stores data to be multiplied by the tap coefficients for the sum-of-products calculation. The pointer P2 designates the same buffer location as input data pointer P1 when a sum-of-products calculation begins, and starting from this initial location, begins the designation.

The sampled time-series data $D_1$, $D_2$, $D_3$, $D_4$, ... $D_p$, $D_{p+1}$, $D_{p+2}$, $D_{p+3}$, $D_{p+4}$ ... are stored in this digital filter as follows: First, data $D_1$ is stored in the buffer at the extreme end of the filter on the Y2 side. Data $D_2$ is stored in the buffer at the extreme end of the filter on the opposite Y1 side. Data $D_3$, $D_4$, ... $D_p$, $D_{p+1}$, are written sequentially in the direction of Y2 from the end buffer on the Y1 side in which data $D_2$ is stored. Accordingly, data $D_{p+1}$ is stored in the buffer adjacent to and on the Y1 side of the buffer in which data $D_1$ is stored. The storage locations of data are continued in this way for one round. The next data $D_{p+2}$ is overwritten on data $D_1$, and data $D_{p+3}$, $D_{p+4}$ ... are then overwritten on data $D_2$, $D_3$, ... . The notations $(D_1)$, $(D_2)$, and $(D_3)$ in Fig. 1 indicate the data that were written at each location before overwriting.

During the above-described data storage, input data pointer P1 designates the storage locations of data.

In other words, input data pointer P1 first designates the buffer at the end of the filter on the Y2 side, and next indicates the end buffer on the Y1 side. Input data pointer P1 then designates a sequence of buffers, shifting successively in the Y2 direction. After designating the buffer at the extreme end in the Y2 direction, input data pointer P1 next designates the end buffer on the Y1 side, following which shifting again continues in the Y2 direction. In Fig. 1, input data pointer P1 is currently designating the second buffer from the Y1 end. Data $D_{p+4}$ is thus overwritten over previously stored data $D_3$.

In a sum-of-products calculation, the multiplication of data and tap coefficients is carried out beginning from the data designated by input data pointer P1 and in a direction opposite that of the storage sequence of data. In other words, delay data pointer P2 has the same value as input data pointer P1 at the start of the sum-of-products calculation, and subsequently shifts in the direction of Y1. When delay data pointer P2 designates the end buffer on the Y1 side, delay data pointer P2 next designates the end buffer on the Y2 side. In Fig. 1, delay data pointer P2 sequentially designates data $D_{p+4}$, $D_{p+3}$, $D_{p+2}$, $D_{p+1}$, $D_p$, ... $D_4$ until the next data $D_{p+5}$ is overwritten on data $D_4$, thereby calculating the sum of products:

$$D_{p+4} + a_1 D_{p+3} + a_2 D_{p+2} + a_3 D_{p+1} + a_4 D_p + ... + a_p D_4$$

In the above-described ring buffer digital filter, data are arranged in a ring made up of p+1 delay elements (buffers). In the data arrangement shown in Fig. 1, for example, first written data $D_4$ and last written data $D_{p+4}$ are arranged next to each other. Consequently, if the two ends Y1 and Y2 are connected, the data from $D_4$ to $D_{p+4}$ are arranged in ring form in the order $D_4$ ... $D_p$, $D_{p+1}$, $D_{p+2}$, $D_{p+3}$, $D_{p+4}$. This ring arrangement allows a large number of data to be sequentially filtered by a small number of buffers. In such a ring arrangement, however, management of pointers is complex; a check being required each time a pointer is shifted, to determine whether or not the pointer has come to a termination point.

In the above-described digital filter of the prior art, the following problems are encountered when carrying out filter processing in a general-purpose microcomputer:

As the first problem, pointer management is complex in a ring buffer-type digital filter because a ring buffer termination check is required each time a pointer is shifted.

As the second problem, the need for real-time characteristics in multimedia processing implies that even higher speeds are demanded in multimedia processing.

SUMMARY OF THE INVENTION

It is an object of the present invention to provide a digital filter for a general-purpose microcomputer having a finite number of input data that features faster filter processing and easier pointer management.

To provide solutions for the above-described problems, the digital filter of the present invention is an FIR digital filter having a delay number p that executes a sum-of-products calculation. The filter comprises a delay device, a first pointing means, a second pointing means, and a sum-of-products calculating means.

The delay device has a linear array of p+N delay elements; wherein, at an initial-setting time for filter processing, 0 is stored in consecutive p delay elements counted from the first end of said linear array and the sequence of input sampled data is stored in the remaining N delay elements in the order of the sequence successively toward the second end of said linear array from the [p+1]$^{th}$ delay element counted from the first end thereof. Hereinafter, a sample of data is referred to as data for brevity.

The first pointing means designates a delay element that stores, of the sequence of input data, data to be taken into every sum-of-products calculation as a first term thereof.

The second pointing means sequentially designates p+1 delay elements successively from the delay element designated by the first pointing means toward the first end, the p+1 delay elements including the delay element designated by the first pointing means.

The sum-of-products calculating means calculates a sum of p+1 products. Here, the p+1 products are the data stored in the delay elements designated by the second pointing means multiplied by predetermined tap coefficients, a first term of the sum of products being data stored in the delay element designated by the first pointing means as well as by the second pointing means.

In the above-described digital filter, the first pointing means designates the [p+j]$^{th}$ delay element counted from the first end of said delay device at a start of the j$^{th}$ sum-of-products calculation.

The second pointing means controls the first pointing means to shift the designation of delay element by just one delay element toward the second end when every sum-of-products calculation is completed.

When the designation of said first pointing means shifts, the second pointing means executes the successive designation of said p+1 delay elements.

The second pointing means repeats the control of the first pointing means and the designation of p+1 delay elements for each time interval set as the delay time until the completion of the filter processing.

Explanation is next presented regarding the operation of the digital filter of the present invention.

For the sake of explanation, identification numbers are assigned to the delay elements as follows: The delay element number at the extreme end on the first end side of the delay device is 1. The delay element number at the extreme end of the second end side, which is opposite the first end side, of the delay device is p+N. Identification numbers are assigned consecutively to delay elements between these two sides. The delay element having the identification number k (1 ≦ k ≦ p+N) is thus referred to as the "number k delay element."

Of the p+N delay elements in the digital filter of the present invention, 0 (initial setting value) is stored in the p delay elements from the number 1 delay element to the number p delay element. The sequence of input data is stored in the N delay elements from the number p+1 delay element to the number p+N delay element. The N data $D_1$, $D_2$, ... $D_N$ are stored in this order in the delay elements from the number p+1 delay element to the number p+N delay element.

With the identification set as described hereinabove, the operation of the digital filter of the present invention can be explained as follows.

The sum-of-products calculations in the present invention are carried out for a consecutive data sequence of linearly arranged p+1 data (assigned with identification numbers that are consecutive integers). This linear arrangement stands in contrast to the p+1 time-series data arranged in ring form in the previously described ring buffer digital filter.

As in the prior art, the numerical formula representation of the j$^{th}$ sum-of-products calculation can be represented by the following equation.

$$X_j = D_j + a_1 D_{j-1} + a_2 D_{j-2} \ ... \ + a_p D_{j-p} \qquad (1)$$

As can be understood from equation (1), the first term of data of the j$^{th}$ sum-of-products calculation $X_j$ is $D_j$, and this data is stored in the number p+j delay element.

The first pointing means designates the number p+j delay element during the j$^{th}$ sum-of-products calculation in accordance with the number of the sum-of-products calculations. With each increase in the number of the sum-of-products calculation, the designation by the first pointing means shifts in the direction of increasing delay element number (toward the second end), progressing sequentially as p+j, p+j+1, p+j+2, ... p+N.

The second pointing means operates to shift designation in the direction of decreasing delay element number (toward the first end), starting from the number p+j delay element during the jth sum-of-products calculation and progressing sequentially to number p+j, p+j-1, p+j-2, ... j.

Management of pointing means is extremely easy because both the first pointing means and second pointing means in the digital filter of the present invention shift the designations of delay elements in only one direction.

Rather than moving data within a delay device as in the well-known FIR, data locations in the digital filter of the present invention are fixed and only the designations by the pointing means shift, thereby allowing the filter processing to speed up.

A method of data-processing in an FIR digital filter of a delay number p for executing a sum-of-products calculation on a sequence of input data of a finite number N according to the present invention comprises the steps of:

constituting a delay device by arranging delay elements equal in number to p+N in a linear array;

labeling consecutive ID numbers from 1 to p+N to identify individual delay elements of said linear array;

at the time of initial setting for filter processing, storing 0 in successive p delay elements of ID numbers 1 to p, and storing, in the order of the sequence of input data, the N input data in N delay elements successively from the delay element of ID number p+1 to the delay element of ID number p+N;

designating the delay element of ID number p+j ($1 \leqq j \leqq N$) as the delay element that stores, of said sequence of input data, data for a first term of a jth sum-of-products calculation;

performing the jth sum-of-products calculation by: sequentially designating p+1 delay elements from said delay element of ID number p+j toward said delay element of ID number 1; of data stored in the sequentially designated delay elements, making the data stored in the delay element of ID number p+j the first term of the jth sum-of-products calculation; sequentially multiplying the other data by p predetermined tap coefficients; and accumulating these multiplication results together with said first term of the jth sum-of-products calculation; and

ending digital filter processing upon completion of the Nth sum-of-products calculation.

The above and other objects, features, and advantages of the present invention will become apparent from the following description referring to the accompanying drawings which illustrate an example of a preferred embodiment of the present invention.

## BRIEF DESCRIPTION OF THE DRAWINGS

Fig. 1 is a diagram illustrating construction of the essential part of the ring buffer-type digital filter of the prior art;

Fig. 2 is a block diagram for explaining one embodiment of the digital filter of the present invention;

Fig. 3 is an explanatory view for a detailed explanation of the operation of the digital filter according to the present invention; and

Fig. 4 is a flow chart for explaining the operation of the digital filter of the present invention.

## DETAILED DESCRIPTION OF THE PREFERRED EMBODIMENTS

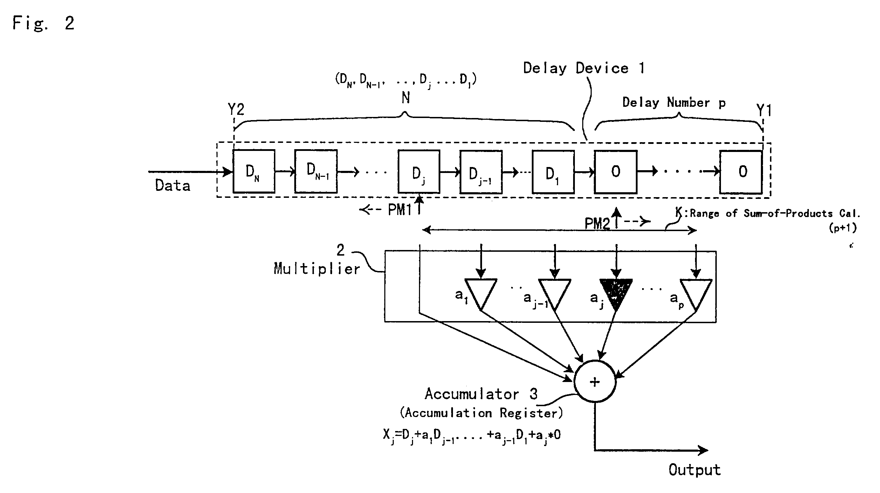

Turning now to Fig. 2, Fig. 2 shows a block diagram for explaining an embodiment of the digital filter of the present invention.

The digital filter of this embodiment is provided with delay device 1, multiplier 2, accumulator 3, pointing device PM1, and pointing device PM2. Delay device 1 is made up of a linear array of delay elements equal in number to N+p, N being the number of data (the samples of data) $D_j$ ($1 \leqq j \leqq N$) to be subjected to filter processing and p being the delay number.

Multiplier 2 is made up of p multiplier elements, these multiplier elements sequentially multiplying the output of the p delay elements by tap coefficients $a_1$, $a_2$, ...$a_p$ and supplying the result as an output. Accumulator 3 accumulates the data stored in the delay element designated by pointing device PM1 (hereinbelow referred to as data designated by pointing device PM1) and output of the p multiplier elements, and supplies the result as a sum-products. In the following description, the range of identification numbers of the delay elements comprising the identification number of the delay element designated by pointing device PM1 and the identification numbers of the delay elements that store the p data to be multiplied by tap coefficients $a_k$ ($1 \leqq k \leqq p$), i.e., the p+1 consecutively located delay elements for which a sum-of-products calculation is carried out, is referred to as "the range of sum-of-products calculation K".

Pointing device PM1 designates the location of the delay element that stores the data of the first term of a sum-of-products calculation. In this invention, N data, $D_1$, ..., $D_j$, ..., $D_{N-1}$, $D_N$ are successively stored from the [p+1][th]

delay element of delay device 1 counting from the first end Y1 toward the second end Y2. In the example shown in Fig. 2, pointing device PM1 currently designates the location of the $[p+j]^{th}$ delay element from the first end Y1 of delay device 1, and data $D_j$ is stored at this location to serve as the data of the first term of the $j^{th}$ sum-of-products calculation.

In this invention, the N data samples $D_1$, ..., $D_j$, ... $D_{N-1}$, $D_N$ are designated sequentially as the first terms of sum-of-products calculations in this order. Accordingly, pointing device PM1 shifts in the direction of the dotted arrow in Fig. 2 (the arrow on the left of the reference symbol PM1) to designate the storage location of the data for the first term of a sum-of-products calculation.

Since one limit of the range of sum-of-products calculation K is designated by pointing device PM1, the range of sum-of-products calculation K as well shifts in the direction of the second end Y2 along with the shift of pointing device PM1 and the increase in the number of sum-of-products calculations.

Pointing device PM2 designates the delay elements that store data to be multiplied by tap coefficients. This designation is carried out successively for the locations of p+1 delay elements starting from the delay element designated by pointing device PM1 and proceeding toward the first end side (the direction of the dotted arrow appearing on the right of the reference symbol for PM2 in Fig. 2). In the example shown in Fig. 2, sum-of-products calculations are carried out with p+1 multiplications and accumulation performed as one cycle of a predetermined delay-time period. (Of the p+1 multiplications, the first term of the $j^{th}$ sum-of-products calculation $D_j$ is regarded as a multiplication of $D_j$ by tap coefficient $a_0=1$.) In the figure, the blackened multiplier element is the element by which multiplication by the tap coefficient is currently being carried out. In addition, the content of the p delay elements from the first end Y1 in Fig. 2 is always the initial set value 0 because data are not stored in these delay elements.

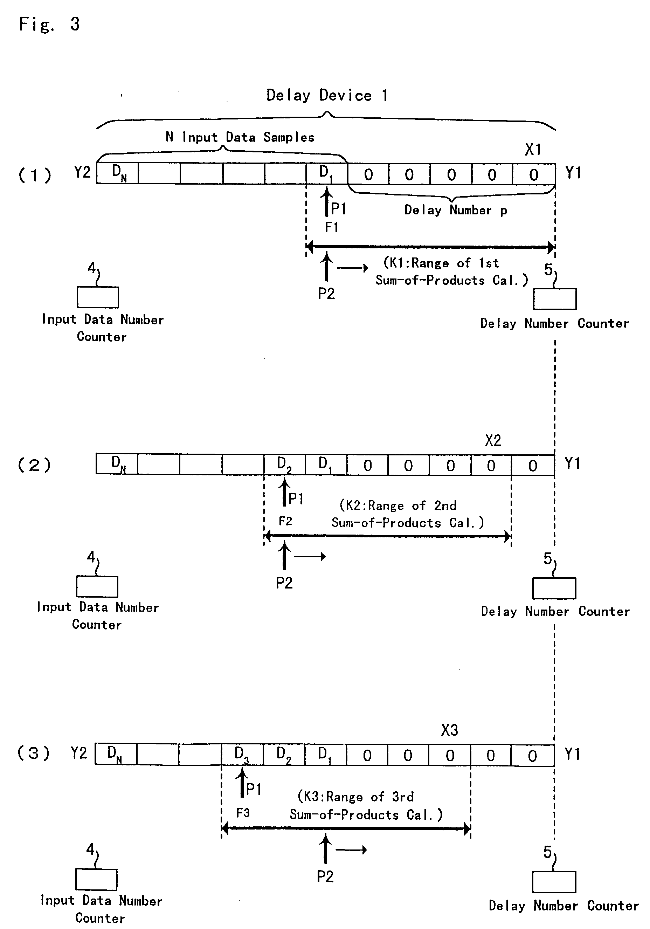

Fig. 3 is an explanatory diagram for illustrating the operation of the digital filter of the present invention in still greater detail.

The pointing device PM1 described hereinabove is provided with input data number counter 4 and pointer P1. Pointer P1 designates the location of the delay element that stores the data of the first term of a sum-of-products calculation. Input data number counter 4 counts the number of sum-of-products calculations that have been carried out. Filter processing using delay device 1 is completed when a number N of sum-of-products calculations have been counted. Input data number counter 4 thus gives the conditions for completing filter processing.

Pointing device PM2 is provided with delay number counter 5 and pointer P2. Pointer P2 designates the delay element that stores data to be multiplied by tap coefficients. Delay number counter 5 provides a count value from 0 to p+1, the time period for generating one cycle of the count values corresponding to the delay time of the digital filter. When delay number counter 5 provides an output of a count value p+1, pointer P1 shifts designation by just one delay element toward the Y2 side. Every time delay number counter 5 provides a count value p+1, input data number counter 4 increases its count by just 1.

The location of pointer P2 is controlled according to the output of delay number counter 5: Pointer P2 indicates the same delay element as that designated by pointer P1 when delay number counter 5 counts 0, subsequently shifting the designation of delay element in the direction of first end Y1 synchronously with each increment in the count value of delay number counter 5.

Delay device 1 can be made up of RAM, and in this case, each delay element is designated by an address. Referring now to Fig. 3(1), the address of data $D_1$ indicated by pointer P1 designates location F1, which is separated by p delay elements from one end Y1 of delay device 1. Filter processing is carried out in the range of sum-of-products calculation K1, which ranges from location F1 to location X1. The result of the first sum-of-products calculation is $D_1 + a_1 0 + a_2 0 + ... + a_p 0$ .

When the first filter processing has been completed, pointer P1 is located at location F2, which is shifted one place (or to the next address) in the direction opposite the first end Y1 as shown in Fig. 3(2). Shift of pointer P1 is performed every predetermined unit of delay time.

Filter processing is next carried out for the range of the second sum-of-products calculation K2, which ranges from location F2 to location X2. The second sum-of-products calculation begins with pointer PM1 designating the next data $D_2$ stored at location F2. This sum-of-products calculation is $D_2 + D_1 a_1 + a_2 0 + ... + a_p 0$ . In this way, high-speed delay processing can be realized by merely shifting the designation of the storage locations of input data samples in delay device 1.

When the filter processing for the sum-of-products calculation of range K2 is completed, pointer P1 moves its designation one delay element toward Y2 side to designate location F3. Fig. 3(3) shows that pointer P2 designates data $D_1$ and accordingly indicates that multiplication $a_2 D_1$ is currently being carried out.

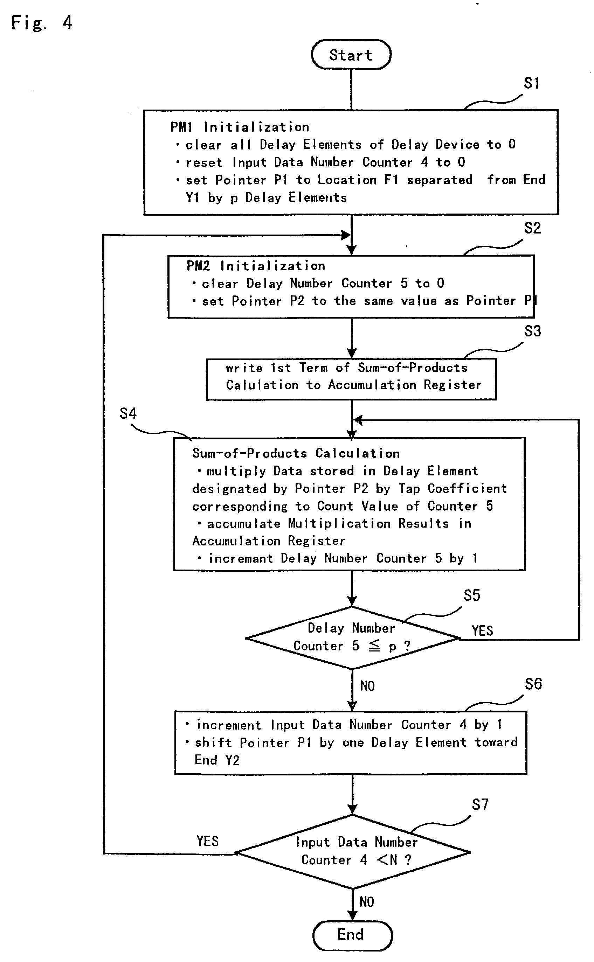

Fig. 4 is a flow chart for explaining the operation of this embodiment.

Initialization of the digital filter is carried out first. Initialization is executed in two steps: the initialization of pointing device PM1 (Step S1) and the initialization of pointing device PM2 (Step S2).

In the initialization process of PM1, all delay elements of delay device 1 are cleared to 0, input data number counter 4 is reset to 0 and pointer P1 is set to location F1, which is separated by p delay elements from end Y1 of delay device 1. In the initialization process of PM2, delay number counter 2 is cleared to 0 and pointer P2 is set to the same value as pointer P1.

Next, the first term of data of the sum-of-products calculation is written to the accumulation register (Step S3). In other words, the first term $D_j$ for the $j^{th}$ sum-of-products calculation $X_j = D_j + a_1 D_{j-1} ... + a_{j-1}D_1 + a_j*0$ is written to the accumulation register. The sum-of-products calculation is next carried out (Step S4). In this processing step, for example, when delay number counter 5 provides count value k, the tap coefficient $a_k$ and data sample $D_{j-k}$ corresponding to this count value k are multiplied. The multiplication result is then transferred to the accumulation register and the count value of delay number counter 5 is incremented by 1.

It is next determined whether or not the incremented count value of delay number counter 5 is less than or equal to delay number p (Step S5), and if the count value of delay number counter 5 is less than or equal to delay number p, the sum-of-products calculation of Step S4 is repeated. The processes of Step S4 and Step S5 are repeated until the count value of delay number counter 5 is equal to p. When the count value of delay number counter 5 is equal to p+1, the sum-of-products calculation has been executed for the entire range of sum-of-products calculation K, i.e., one period of the sum-of-products calculation has been completed.

When a sum-of-products calculation period has been completed, the count value of input data number counter 4 is incremented by 1 and pointer P1 is shifted one place toward end Y2 of delay device 1 (refer to Fig. 2) in order to execute sum-of-products calculations for the next data (Step S6). It is next judged whether or not the incremented count value of input data number counter 4 is less than the number of data N (Step S7). If the count value of input data number counter 4 is less than the number of data N, pointing device PM2 is initialized (Step S2) in order for sum-of-products calculations to be resumed for new designated data, and the processes of Steps S2-S7 are repeated until the count value of input data number counter 4 becomes equal to the number of data N. When the count value of input data number counter 4 is equal to or greater than the number of data N, filter processing of the N data samples that are the object of processing has been completed.

Filter processing in a digital filter of the present invention is executed based on the control of a processor (not shown) in accordance with a control program that is stored in a recording medium (also not shown). In the following description, the hardware system that includes the above-described processor (not shown), the RAM that constitutes the delay device, the input data number counter, and the delay number counter is referred to as a "computer." (The first and second pointers can be realized by software.)

The procedures necessary for executing at least the following processing in a computer are described in the control program of this invention:

An initial setting process at the time of initial setting of the filter processing in which 0 is stored in p delay elements from the first end of the array, and the N input data are sequentially stored in the order of the sequence in the N delay elements from the $[p+1]^{th}$ delay element counting from the first end toward the second end side;

a first filtering process in which the $[p+1]^{th}$ delay element counting from the first end of the above-described delay device is designated as the delay element that stores, of the data sequence made up of N input data, a data sample for the first term of a first sum-of-products calculation;
a second filtering process in which p+1 delay elements are successively designated starting from the delay element that was designated in the first filtering process toward the first end;
a third filtering process in which, of the data stored in the delay elements designated in the second filtering process, the data stored in the delay element that was designated in the first filtering process is made the first term of a sum-of-products calculation, the other data are sequentially multiplied by p predetermined tap coefficients, and in which the multiplication results are accumulated together with the first term of the sum-of-products calculation;
a fourth filtering process in which, when the third filtering process has been completed, the location designated as the delay element that stores the data of the first term of the second sum-of-products calculation is shifted one delay element toward the second end of the delay device; and
a successive process in which the first to fourth filtering processes are subsequently repeated in the same way until the $N^{th}$ sum-of-products calculation has been completed.

Finally, the present invention has the following merits:

(1) Filter processing can be accelerated by realizing delay by merely shifting the pointer to designate the delay element that stores input data in the delay device. This acceleration is enabled because the filter processing of the present invention needs to access the memory fewer times than when realizing delay by the prior-art process. In concrete terms, the present invention can be completed in just $(5 \times p + 7) \times N$ steps, in contrast to the prior-art method, which requires, for example, approximately $(8 \times p + 8) \times N$ steps. In terms of percentage, the present invention affords a reduction in processing time to just 63% that of the prior art. In the filtering process, input data are processed in equal time intervals. For example, in a case in which input data are sampled at 8 KHz, or 125 μsec in real time, and the processing time for one input data sample is approximately 100 μsec in the prior art, the present invention enables processing in 63 μsec. As a result, the time that can be used for application processing other than filter processing increases by approximately 37 μsec, and overall, a time interval of approximately 62 μsec can be used for application processing other than filter processing.

(2) Pointer management for realizing delay is simplified as compared with the ring buffer of the prior art.

Although delay is realized by pointer control in the ring buffer of the prior art as in the present invention, buffers are provided in the ring buffer only in accordance with the delay number. When shifting the pointer of the ring buffer, a check is always necessary to judge whether or not the pointer is at the end of the ring buffer, and if at the end, the pointer must be shifted to the beginning of the ring buffer.

As an example, shifting of the pointer requires about $(6 \times P + 10) \times N$ steps in the method of the prior art. The present invention involves only shifting of the pointer without requiring a check for termination, thereby enabling the processing time to reduce to just 83% of the prior art. As with the previously described merit (1), the time that can be used for applications increases by about 17 μsec, meaning that overall, a time interval of about 42 μsec can be used for applications other than filter processing. When applied to TrueSpeech 8.5, which is a speech compression format based on an algorithm provided by DSPG. Inc. and incorporated in Windows 95 standards, the present invention enables an improvement in performance of approximately 12%.

It is to be understood, however, that although the characteristics and advantages of the present invention have been set forth in the foregoing description, the disclosure is illustrative only, and changes may be made in the size and arrangement of the parts within the scope of the appended claims.

## Claims

1. An FIR digital filter of a delay number p that executes a sum-of-products calculation for a sequence of input data of a finite number N; characterized by:

   a delay device having a linear array of p+N delay elements; wherein, at an initial-setting time for filter processing, 0 is stored in consecutive p delay elements counted from the first end of said linear array and said sequence of input data is stored in the remaining N delay elements in the order of said sequence successively toward the second end of said linear array from the $[p+1]^{th}$ delay element counted from said first end thereof;
   a first pointing means for designating a delay element that stores, of said sequence of input data, data to be taken into every sum-of-products calculation as a first term thereof;
   a second pointing means for sequentially designating p+1 delay elements successively from the delay element designated by said first pointing means toward the first end, said p+1 delay elements including the delay element designated by said first pointing means; and
   sum-of-products calculating means for calculating a sum of p+1 products, said p+1 products being the data stored in said delay elements designated by said second pointing means multiplied by predetermined tap coefficients, a first term of the sum of products being data stored in the delay element designated by said first pointing means as well as by said second pointing means;
   wherein:
   said first pointing means designates the $[p+j]^{th}$ delay element counted from the first end of said delay device at a start of the $j^{th}$ sum-of-products calculation; and
   said second pointing means controls said first pointing means to shift the designation of delay element by just one delay element toward the second end when every sum-of-products calculation is completed; when the designation of said first pointing means shifts, executes the successive designation of said p+1 delay elements; and repeats the control of said first pointing means and said designation of [p+1] delay elements for each time interval set as the delay time until the completion of the filter processing.

2. A digital filter according to claim 1 wherein said second pointing means comprises:

   a delay number counter, and
   a second pointer;
   wherein said delay number counter repeatedly provides a count value that increases by one from 0 to p+1 each time interval set as the delay time; and
   said second pointer designates the delay element designated by the first pointing means when said delay number counter outputs 0, and subsequently shifts designation of delay element toward the first end of said array in accordance with the count value of said delay number counter until said delay number counter supplies a count value of p.

3. A digital filter according to claim 1 or claim 2 wherein said first pointing means comprises: an input data number counter, and

a first pointer
wherein the count value of said input data number counter is set to 0 at the start of filter processing and increases by 1 when said delay number counter supplies a count value of p+1, and said input data number counter provides a signal indicating completion of filter processing when the count value of said input data number counter reaches N; and

said first pointer designates the $[p+1]^{th}$ delay element counted from the first end of said delay device at initial setting of filter processing, and subsequently shifts designation of delay element by one delay element toward the second end side of said delay device when said delay number counter supplies a count value of p+1.

4. A digital filter according to claim 1 wherein:

said delay device is a region of RAM designated by N+p consecutive addresses; and
said delay elements are regions designated by each address.

5. A method of data-processing in an FIR digital filter of a delay number p for executing a sum-of-products calculation on a sequence of input data of a finite number N; characterized by the steps of:

constituting a delay device by arranging delay elements equal in number to p+N in a linear array;
labeling consecutive ID numbers from 1 to p+N to identify individual delay elements of said linear array;
at the time of initial setting for filter processing, storing 0 in successive p delay elements of ID numbers 1 to p, and storing, in the order of the sequence of input data, the N input data in N delay elements successively from the delay element of ID number p+1 to the delay element of ID number p+N;
designating the delay element of ID number p+j $(1 \leqq j \leqq N)$ as the delay element that stores, of said sequence of input data, data for a first term of a $j^{th}$ sum-of-products calculation;
performing the $j^{th}$ sum-of-products calculation by: sequentially designating p+1 delay elements from said delay element of ID number p+j toward said delay element of ID number 1; of data stored in the sequentially designated delay elements, making the data stored in the delay element of ID number p+j the first term of the $j^{th}$ sum-of-products calculation; sequentially multiplying the other data by p predetermined tap coefficients; and accumulating these multiplication results together with said first term of the $j^{th}$ sum-of-products calculation; and ending digital filter processing upon completion of the $N^{th}$ sum-of-products calculation.

6. A recording medium on which is stored a control program for controlling, by means of a computer, an FIR digital filter processing, said FIR digital filter being provided with a linear array of p+N delay elements, N being a number of input data and p being a delay number; said control program describing procedures for causing the computer to perform a sum-of-products calculation on a sequence of the N input data, said procedures being characterized in executing:

an initial setting process at the time of initial setting of filter processing in which 0 is stored in successive p delay elements from the first end of said linear array, and the N input data are stored, in the order of the sequence of input data, in N delay elements successively from the $[p+1]^{th}$ delay element counted from the first end of said liear array toward the second end;
a process in which the $[p+j]^{th}$ $(1 \leqq j \leqq N)$ delay element counted from the first end of said linear array is designated as the delay element that stores, of said sequence of input data, data for a first term of a $j^{th}$ sum-of-products calculation;
a process in which the $j^{th}$ sum-of-products calculation is performed by: sequentially designating p+1 delay elements from said $[p+j]^{th}$ delay element, including said $[p+j]^{th}$ delay element, toward said first end; of data stored in the sequentially designated delay elements, making the data stored in the $[p+j]^{th}$ delay element the first term of the $j^{th}$ sum-of-products calculation; sequentially multiplying the other data by p predetermined tap coefficients; and accumulating these multiplication results together with said first term of the $j^{th}$ sum-of-products calculation; and
a process of ending digital filter processing upon completion of the $N^{th}$ sum-of-products calculation.

7. A general-purpose microcomputer having a digital filter according to claim 1.

# Fig. 1

## Prior art

Delay Number p

$(D_1)$                                              $(D_3)$     $(D_2)$

| Y2 | $D_{p+2}$ | $D_{p+1}$ | $D_p$ | — — — — — — — | $D_4$ | $D_{p+4}$ | $D_{p+3}$ | Y1 |

P1

P2

Fig. 2

Fig. 3

Delay Device 1

N Input Data Samples

X1

(1) Y2 | $D_N$ | | | | | | $D_1$ | 0 | 0 | 0 | 0 | 0 | Y1

↑P1

Delay Number p

F1

(K1:Range of 1st
Sum-of-Products Cal.)

↑
P2

4

Input Data Number
Counter

5

Delay Number Counter

X2

(2) | $D_N$ | | | | | $D_2$ | $D_1$ | 0 | 0 | 0 | 0 | 0 | Y1

↑P1

(K2:Range of 2nd
Sum-of-Products Cal.)

F2

↑
P2

4

Input Data Number
Counter

5

Delay Number Counter

X3

(3) Y2 | $D_N$ | | | | $D_3$ | $D_2$ | $D_1$ | 0 | 0 | 0 | 0 | 0 | Y1

↑P1

(K3:Range of 3rd
Sum-of-Products Cal.)

F3

↑
P2

4

Input Data Number
Counter

5

Delay Number Counter

Fig. 4

```
                    ( Start )
                        │
                        ▼                              S1
┌─────────────────────────────────────────────────────────┐
│ PM1 Initialization                                       │
│  · clear all Delay Elements of Delay Device to 0         │
│  · reset Input Data Number Counter 4 to 0                │
│  · set Pointer P1 to Location F1 separated  from End     │
│    Y1 by p Delay Elements                                │
└─────────────────────────────────────────────────────────┘
                        │
     ┌──────────────────┤
     │                  ▼                              S2
     │    ┌──────────────────────────────────────────────┐
     │    │ PM2 Initialization                            │
     │    │  · clear Delay Number Counter 5 to 0          │
     │    │  · set Pointer P2 to the same value as Pointer P1 │
     │    └──────────────────────────────────────────────┘
     │                  │                              S3
     │         ┌──────────────────────────────────────┐
     │         │ write 1st Term of Sum-of-Products     │
     │         │ Calulation to Accumulation Register   │
     │         └──────────────────────────────────────┘
     │                  │
     │  S4              ▼◄─────────────────────────────┐
     │    ┌──────────────────────────────────────────┐ │
     │    │ Sum-of-Products Calculation              │ │
     │    │  · multiply Data stored in Delay Element │ │
     │    │ designated by Pointer P2 by Tap Coefficient │ │
     │    │ corresponding to Count Value of Counter 5 │ │
     │    │  · accumulate Multiplication Results in  │ │
     │    │ Accumulation Register                    │ │
     │    │  · incremant Delay Number Counter 5 by 1 │ │
     │    └──────────────────────────────────────────┘ │
     │                  │                    S5         │
     │                  ▼                               │
     │            ◇ Delay Number ◇  YES                 │
     │            ◇ Counter 5 ≦ p ? ◇──────────────────┘
     │                  │
     │                  │ NO                  S6
     │    ┌──────────────────────────────────────────┐
     │    │ · increment Input Data Number Counter 4 by 1 │
     │    │ · shift Pointer P1 by one Delay Element toward │
     │    │   End Y2                                   │
     │    └──────────────────────────────────────────┘
     │                  │
     │                  ▼                    S7
     │  YES      ◇ Input Data Number ◇
     └───────────◇ Counter 4 <N ? ◇
                        │
                        │ NO
                    ( End )
```